# EUROPEAN PATENT APPLICATION

(11) **EP 1 193 758 A1**
(43) Date of publication of application: **03.04.2002**
(21) Application number: 00830646.6
(22) Date of filing: 02.10.2000
(51) Int. Cl.: H01L 23/58, H01L 27/02, G06K 19/073

(54) **Anti-deciphering contacts**

(71) Applicant: STMicroelectronics S.r.l., 20041 Agrate Brianza (Milano) (IT)
(72) Inventor: Vajana, Bruno, 24100 Bergamo (IT); Patelmo, Matteo, 20056 Trezzo Sull'Adda (IT)
(74) Representative: Pellegri, Alberto

(57) **Abstract**

Anti-deciphering contacts and/or interconnection vias schemes for integrated devices, including the formation of a plurality of false contacts and/or false interconnection vias, intercepted as true contacts and true interconnection vias by lines patterned in a metallization layer deposited over an insulating dielectric layer or multilayer through which the true contacts and/or the true interconnection vias are formed. False contacts and false vias extending in the respective dielectric layer or multilayer for a depth insufficient to reach the active areas of a semiconductor substrate in the case of false contacts or structures of electrically conductive material defined in a layer of conductive material below said dielectric layer or multilayer in the case of interconnection vias.

## Description

The present invention relates to integrated circuits and in particular to complex devices for which it is useful or necessary to prevent or at least to make extremely hard their duplication.

The large diffusion of the so-called "smart-cards" for applications such as credit cards, medical anamnesis memory cards, electronic driving license and similar, impose that such integrated devices guarantee a high security of stored data.

To this end, both hardware and software used in these devices must be designed and realized in such a way as to satisfy this need of protection.

On the other side, sophisticated "reverse engineering" techniques are known and used, often illegally, to duplicate integrated circuits from commercially available samples, causing a great economic damage to the company who designed them.

It is evident how, whether devices are destined to applications in which it is particularly important to keep stored data undecipherable or result from a long and expensive development process, it is important to vanify attempts of duplicating then through "reverse engineering" techniques including microscope inspection of the integrated circuit.

An inviolability of the hardware system may represent an insuperable obstacle to the identification of "working codes", that is an ultimate protection in addition to the software ciphering of stored data.

Known reverse engineering techniques allow inspection of an integrated circuit to be duplicated by means of an optical or electronic microscope.

It is evident the need and/or utility of introducing means that make vain the objective of such inspections and that practically make impossible the deciphering even using destructive inspection techniques.

It has now been found a scheme of anti-deciphering contacts for integrated devices in which a plurality of false contacts and/or false interconnection vias are realized in a way to make them totally indistinguishable from true contacts and true interconnection vias, respectively, even by a destructive inspection of the device. In practice, false contacts and false interconnection vias are intercepted (connected) like true contacts and true interconnections vias by metal lines defined in the respective layer of conducting material.

Differently from true contacts and true interconnection vias that extend throughout the whole thickness of an insulating dielectric layer or multilayer to reach and establish electric paths with the respective active area, in case of contacts, or with another conducting element of the integrated structure, in case of interconnection vias, false contacts and false interconnection vias are realized using a dedicated mask, complementary to the mask of true contacts or of true interconnection vias, and extend only partially through the thickness of the respective insulating dielectric layer or multilayer, thus remaining as electrically isolated "appendices" without any function.

False contacts and false vias so realized do not establish any current path even if they are at the potential of the circuit node to which they are referred (connected) through the respective metallization line that intercept them.

The only way of establishing their false nature would be to section the device to establish for each contact and each interconnection via way of the device, whether it is true or false. It is easy to understand that this would be a hugely burdening job that would require to buy and to sacrifice a very great number of identical devices.

The invention is defined in the appended claims.

**Figure 1** is a generic layout portion of a patterned metallization layer showing that true contacts and false contacts of the device are not distinguishable from each other.

**Figures** from **2** to **8** schematically show the realization of false contacts according to the present invention.

**Figures** from **9** to **15** illustrate the sequence of process steps to realize false contacts in a so-called LIL process (Local Interconnect Layer).

**Figures 16** and **17** depict an application of the invention for realizing false interconnection vias between conductive structural elements of an integrated circuit defined in the n^{th} and the n+1^{th} metallization levels, respectively.

The integrated structures of Figs. from 1 to 8 and representing a flash memory cell and two transistors are depicted for sample purposes, being quite sufficient to illustrate the technique of the present invention. In reality, the scheme of anti-deciphering contacts of the invention may be generally implemented on the whole layout of the integrated circuitry, even on structures different from the ones depicted in the figures.

Because of the importance of CMOS processes, the invention will be described referring to a typical CMOS process for realizing nonvolatile flash memory devices having contacts made by tungsten plugs. Of course, this particular process condition is not essential, as will be apparent to any skilled person, in practice the technique of the invention may be used even in case the contacts are directly established by depositing a metallization layer.

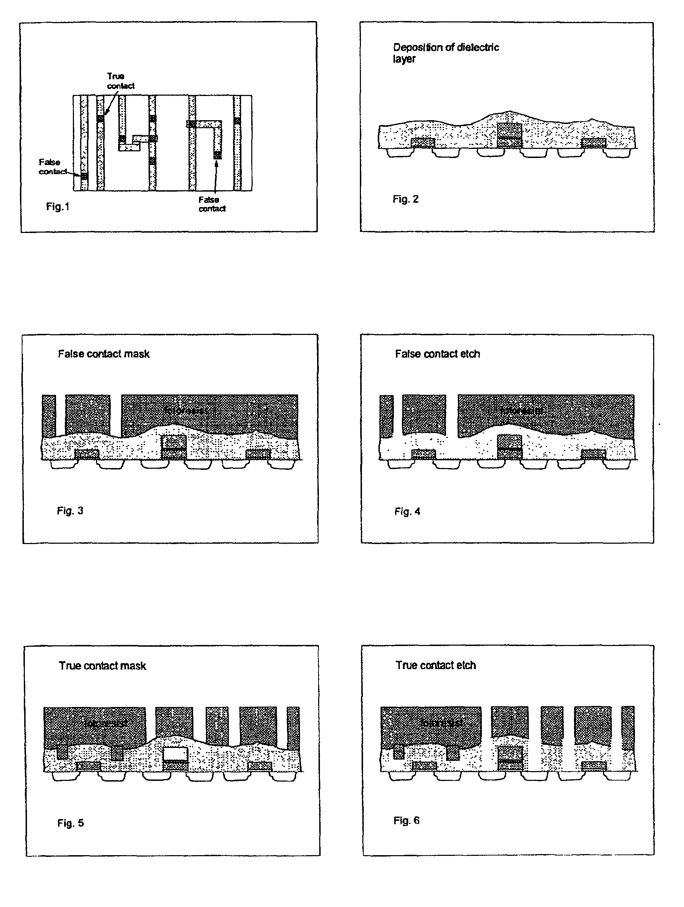

A sectional view of a wafer, during the fabrication step in which a dielectric layer 1 is deposited for isolating the previously formed structures, of completely dcfincd integrated functional structures, is depicted in Fig. 2.

At this point, priority may be indifferently given to the formation of true or false contacts that are defined by using respective masks. In the example of Fig. 3, a fotoresist mask for false contacts is formed first.

As depicted in Fig. 4, an incomplete etching of the insulating dielectric layer 1 is carried out through the openings of the mask, stopping the etching after a certain etching time, sufficient to etch no more than a certain fraction of the thickness of the dielectric layer 1.

After having removed the fotoresist mask of false contacts, a new fotoresist mask, for true (functional) contacts of the integrated structures, is formed and defined, as depicted in Fig. 5.

Through the openings of this mask the true contacts are opened continuing the etching metal reaching the semiconductor in the active areas, as depicted in Fig. 6, according to well known and commonly used etching techniques.

After having removed the second mask relative to the true contacts, the deposition and the etch-back of tungsten are carried out, forming tungsten plugs both in the openings of true contacts as well as in the holes of false contacts formed in the dielectric layer 1.

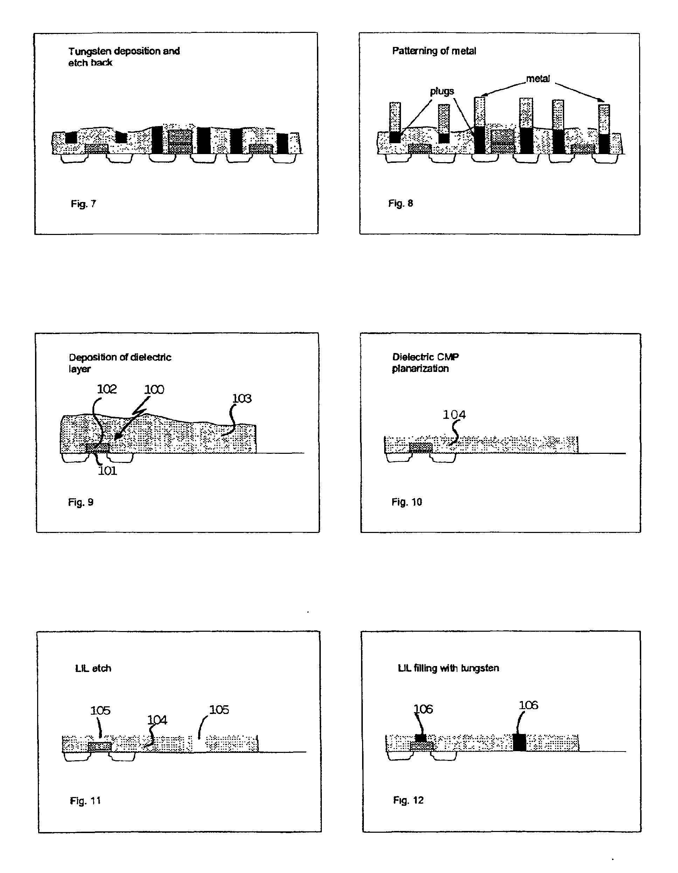

A sectional view of the wafer, after deposition and etch-back of tungsten plugs 2, is depicted in Fig. 7.

According to common manufacturing techniques, a metal layer is then deposited onto the whole surface of the wafer and, through a suitable mask, the conductive lines are defined, according to a layout as the one depicted in Fig. 1.

As depicted in Fig. 8, the lines so defined intercept all the tungsten plugs, both those relative to functional contacts of the integrated structures as well as those relative to false contacts. Naturally the intercepting of electrically isolated tungsten plugs of the false contacts will not have any effect on the operation of the integrated circuit that is defined by the current paths which the tungsten plugs of true contacts belong to.

Through an inspection of the patterned metal (Fig. 1) it is not possible to establish which contact is a true contact and which one is a false contact, merely the presence of contacts can be detected.

On the other hand, the doubt should be solved for each and every contact location by sectioning the dice to establish whether the particular contact is true or not. It is evident that this can hardly be done because of the extraordinary cost that is implied.

The present invention can be applied in a peculiarly convenient way in advanced CMOS processes in which local interconnections or more briefly LIL (Local Interconnect Layer) are used to realize electrical connections or interconnection vias between conductive elements defined on different levels and contacts with active areas. In these processes the contacts on the active areas (and eventually the interconnection vias) are realized in two steps: by a first masking step that defines the contacts through a first dielectric layer, the "lower portion" of the true contacts is realized; by a second masking step the interconnection vias are realized and at the same time it is also realized the "upper portion" of the contacts on active areas across throughout the second dielectric layer. With By this second masking step, already contemplated in the normal process, besides completing the true contacts on active areas (coincident with the lower portions of the contacts realized with the first masking step) and the true vias on the patterned polysilicon layer, false contacts and false vias are also defined according to the present invention.

The significative steps of a manufacturing process of an integrated circuit, according to a preferred embodiment of the present invention, are depicted in the Figures from 9 to 15. This embodiment concerns a so-called LIL (Local Interconnect Layer) process for realizing interconnection vias.

The invention is applicable to a generic CMOS process for manufacturing general purposes integrated circuits, memory devices, gate arrays and logic circuitry, as well as to any other manufacturing process of integrated devices.

The figures are schematic partial sections of the device not to scale.

Active devices are formed on a semiconductor substrate according to a conventional process. A gate oxide layer is formed on pre-defined active areas of transistors and eventually of memory cells. A first polysilicon layer is deposited on the wafer surface, doped and patterned for realizing the gates of transistors and eventually the floating gates of memory cells. In the case realization of floating gate memory cells, a dielectric interpoly layer and a second polysilicon layer are also formed and patterned, according to a normal fabrication process.

The figures depict the cross section along a section line passing through the drain and the source region of a transistor identified with 100. The gate oxide 101 and the polysilicon gate 102 formed thereon are clearly recognizable.

After realization of the active elements of the device, a first dielectric layer 103 is formed. This layer is typically realized by a chemical vapor deposition technique or CVD (Chemical Vapor Deposition). Preferably, if the device includes nonvolatile memory cell, the layer 103 is a BPSG, i.e. a silicon oxide doped with phosphorous and boron. Nevertheless, depending on the specific application, other dielectrics can be used, such as undoped oxides or PSG or oxynitrides. In any case the layer 103 must be formed by a material and a technique that provide for enhanced conformability and insulating characteristics typical of any pre-metallization layer. The device obtained at the end of this step is depicted in Fig. 9.

As depicted in Fig. 10, this first dielectric layer surface is preferably planarized. This minimizes mechanical stresses in the layers that will be formed successively thereon and in particular in the so-called local interconnection layer.

Planarization is preferably carried out by a CMP technique, i.e. Chemical Mechanical Polishing or by lapping the surface by a chemical mechanical process. Of course, the planarization may be done by any suitable alternative technique, for example by thermal reflow. It should be remarked that this step remains optional though preferred. In fact, if the first dielectric layer is sufficiently flat, planarization may not be required altogether.

As depicted in Fig. 10, the planarization partially removes the previously deposited dielectric layer 103. In any case, whether planarization is realized or not, the final thickness of the first dielectric layer 104 is preferably comprised between 200 and 100 nm.

As depicted in Fig. 11, openings defined through the dielectric layer 104 by a first masking step and subsequent etching. These openings 105 are defined only in correspondence of locations of contacts that need to be realized with active areas and of local interconnection vias. Typically, as depicted in the figure, the openings open active areas on the silicon substrate and polysilicon gate structures. It must be reminded that, according to this invention, in this first masking and etching step, locations in which false contacts and false vias will be realized are not defined.

Subsequently, the openings are filled, according to any known technique for the formation of the so-called tungsten "plugs".

According to the local interconnect layer (LIL) technique, certain of these filled openings constitute the local interconnection vias. The tungsten filler is identified with 106 in Fig. 12.

According to a preferred embodiment, a so-called "barrier" layer, composed of stacked layers of titanium and titanium nitride (Ti/TiN) are deposited first. Successively, a tungsten is deposited and etched back by a CMP technique in order to leave the tungsten only inside the openings of the contacts and of vias.

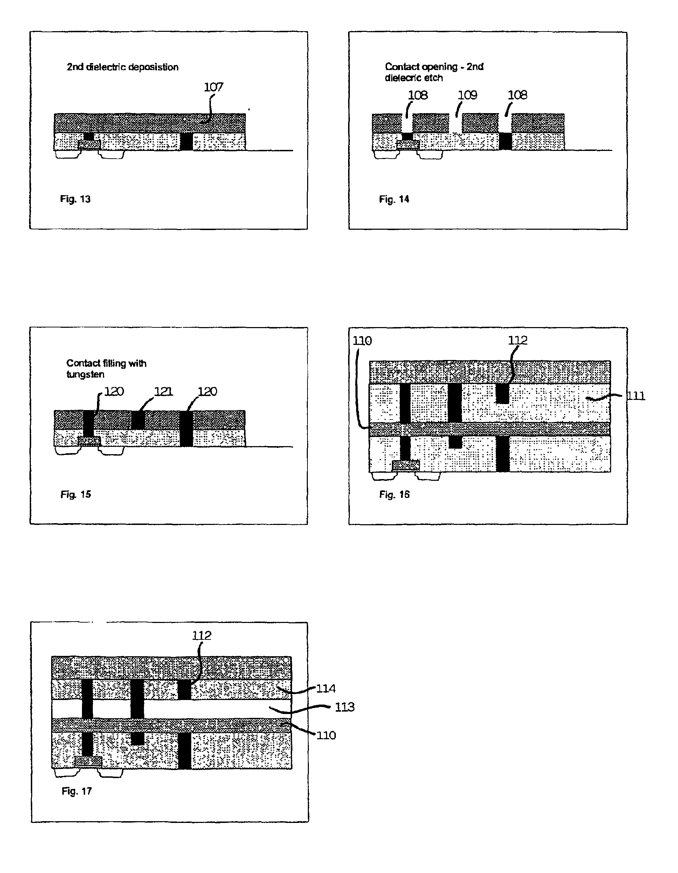

According to the local interconnect layer technique, a second dielectric layer 107 is deposited on the wafer as depicted in Fig. 13.

This second dielectric layer is preferably formed by a CVD technique and it is preferably constituted by a TEOS (tetraethylorthosilicate) layer. However, the layer 107 may be constituted by a different dielectric material, for example a different oxide, doped or not, or even an oxynitride, provided that it has appropriate chemical-physical and morphological characteristics to ensure a good electric insulation of the underlying integrated structure. If necessary, even this second dielectric layer is planarized by any of the known techniques. The final thickness of this second dielectric layer 107 may be generally comprised between 200 and 1500nm.

According to the present invention a second mask is formed on the wafer surface (not shown in the figures), defining the contacts and the interconnection vias according to the local interconnect layer technique.

By this second mask openings are defined and produced through the second diclcctric layer 107 in correspondence of the locations of the active or real contacts and of real vias as well as in correspondence of false contacts and of false vias. The second dielectric layer 107 is eventually etched to realize a first plurality of openings 108 coincident with the previously realized tungsten plugs and a second plurality of openings 109 that practically end onto the underlying first dielectric layer 104. The openings 109 thus realized will constitute as many false contacts and false vias.

As depicted in Fig. 15, the openings 108 and 109 are filled with tungsten to form plugs 120 and 121, according the previously described technique of deposition and etch-back.

In this preferred embodiment of the present invention, it is advantageously not necessary to use an additional mask dedicated to the realization of false contacts and false vias, but it is sufficient to modify the mask that is already contemplated in the process for opening contacts and vias in the second dielectric layer.

The formation of false contacts and false vias is inexpensive and extremely easy because the etching can be terminated automatically on the first dielectric layer.

Although the invention has been described by referring to the realization of contacts and vias between a local interconnect layer and an underlying conductive material such a polysilicon gate, it may be implemented even when realizing vias between any two metal levels.

Figs. 16 and 17 depict a possible application of the present invention to vias between the N^{th} and the N+1^{th} metals. In the sample illustration, the first and the second metallization layers are depicted.

In the figures a first metal 110, patterned in conductive lines may be a conventional layer of aluminum or of an alloy. The integrated device may even contemplate LIL interconnection vias, typically of tungsten, as the ones already described in relation to the preceding Figures 9 to 15.

According to the embodiment depicted in Fig. 16, a so-called intermetal dielectric layer 111 is formed by CVD. This first intermetal dielectric 111 is preferably a TEOS and may have a thickness between 500 and 1000nm. The thickness of the dielectric is correlated to the thickness of the metal layers and must be sufficient to make negligible eventual capacitive couplings.

According to the present invention false vias, labeled with 112, are formed in the same manner as already described in relation to Figures 2 to 8.

In another embodiment, depicted in Fig. 17, the intermetal dielectric is constituted by at least two superimposed layers. In this case, a process similar to the one described with reference to Figures 9 to 15 is advantageously followed. Dielectric layers are typically formed by CVD deposition followed by an eventual planarization step. Typically a first layer 113 is constituted by an oxide formed by HDP deposition technique (High Density Plasma), while the second dielectric layer 114 is preferably a TEOS. The total thickness of the two stacked layers may range between 600 and 1200nm.

False vias 112 according to the invention are formed only in the second dielectric layer.

By forming false vias between any or all adjacent metals and false contacts, permanently stored data and/or the characterization of an integrated circuit is rendered practically undecipherable through reverse engineering inspection techniques.

## Claims

1. Anti-deciphering contacts and/or interconnection vias schemes for integrated devices, including the formation of a plurality of false contacts and/or false interconnection vias, intercepted as true contacts and true interconnection vias by lines patterned in a metallization layer deposited over an insulating dielectric layer or multilayer through which the true contacts and/or the true interconnection vias are formed, and extending in the respective dielectric layer or multilayer for a depth insufficient to reach the active areas of a semiconductor substrate in the case of false contacts or structures of electrically conductive material defined in a layer of conductive material below said dielectric layer or multilayer in the case of interconnection vias.

2. The scheme of anti-deciphering contacts and/or interconnection vias of claim 1, wherein the conductive material of said layer below said dielectric layer or multilayer in which are defined said conductive structures belongs to the group composed of polysilicon, silicide, aluminum, titanium, iridium, rhodium, platinum, gold, palladium, zirconium, tantalum, niobium and alloys of at least one of said metals.

3. The scheme of anti-deciphering contacts and/or interconnection vias of claim 1, wherein said dielectric layer or multilayer is composed, at least partially, of a material belonging to the group composed of silicon oxide, silicon oxide doped with phosphorous and boron, oxynitride and tetraethylorthosilicate.

4. An integrated device, **characterized in that** it includes a plurality of false contacts and/or false vias according to claim 1.

5. The integrated device of claim 4, realized in CMOS technology using a local interconnect layer to contact active areas of CMOS transistors, **characterized in that** a first or lower portion of true contacts and/or of true interconnection vias is realized through a first dielectric layer or multilayer by a first masking and etching step and a second or upper portion of said true contacts and/or of said interconnection vias as well as said false contacts and/or false interconnection vias are realized through a second dielectric layer or multilayer by a second masking and etching step.

6. The integrated device of claim 4, **characterized in that** it comprises both false contacts and false interconnection vias.

7. The integrated device of claim 4, **characterized in that** it comprises false interconnection vias between the N^{th} and the N+1^{th} metallization layers.

8. A method of vanifying a reverse engineering inspection of an integrated circuit whose unauthorized duplication must be prevented, comprising realizing a plurality of false contacts and/or false interconnection vias, intercepted as true contacts and as true interconnection vias, respectively, by lines defined in a metallization layer deposited onto an insulating dielectric layer or multilayer through which said true contacts and/or said true interconnection vias are realized, and extending through the respective dielectric layer or multilayer for a depth insufficient to reach active areas of a semiconductor substrate in the case of false contacts or structures of an electrically conductive material defined in a layer of conductive material below said dielectric layer or multilayer in the case of interconnection vias.
